# DEMANDE DE BREVET EUROPEEN

(11) **EP 1 750 372 A1**
(43) Date de publication de la demande: **07.02.2007**
(21) Numéro de dépôt: 06117334.0
(22) Date de dépôt: 17.07.2006
(51) Int. Cl.: H03K 5/22, H03K 17/16, H03M 1/00, G01R 19/165

(54) **Dispositif de comparaison d'un signal d'entrée avec une consigne, et circuit électronique correspondant**

(30) Priorité: 29.07.2005 FR 0508191
(71) Demandeur: ATMEL NANTES SA, 44306 Nantes Cédex 3 (FR)
(72) Inventeur: Courtel, Karl, 44400 Reze (FR)
(74) Mandataire: Guéné, Patrick Lucien Juan Joseph

(57) **Abrégé**

L'invention concerne un dispositif de comparaison (100), recevant un signal d'entrée analogique (INPUT) et une valeur de consigne (VCONS), et délivrant un signal de sortie numérique (OUTPUT_3). Le dispositif (100) comprend un comparateur à un seuil (1) recevant le signal d'entrée et la valeur de consigne, le comparateur génère un signal résultant (RESULT) qui est fonction du résultat de la comparaison.

Selon l'invention, un tel dispositif (100) comprend des moyens d'échantillonnage (4) du signal résultant et des moyens de commande (3), permettant de bloquer les moyens d'échantillonnage (4), après une commutation du signal d'entrée, et ce tant qu'un mécanisme de temporisation (32) n'indique pas qu'une durée de temporisation déterminée (TEMP_VALUE) est écoulée depuis la vérification d'un critère d'instabilité prédéterminé. Le mécanisme de temporisation (32) est réinitialisé avec la durée de temporisation à chaque fois qu'un critère d'instabilité prédéterminé est vérifié. Les moyens d'échantillonnage (4) permettent, s'ils ne sont pas bloqués, de copier le signal résultant (RESULT) en sortie du dispositif (100).

## Description

### 1. Domaine de l'invention

Le domaine de l'invention est celui des circuits électroniques intégrés et plus particulièrement des circuits comprenant des comparateurs de signaux analogiques, tels que les microcontrôleurs ou encore les systèmes sur puces électroniques (« systems on chip » en anglais).

Plus précisément, l'invention concerne la génération d'un signal de comparaison dans de tels circuits.

### 2. Solutions et inconvénients de l'art antérieur

On discute ci-après les inconvénients de l'art antérieur à travers le cas particulier des comparateurs embarqués dans un microcontrôleur utilisé dans un système d'asservissement.

Les systèmes d'asservissement sont des systèmes dont la sortie doit respecter le plus fidèlement possible une consigne. Pour ce faire, ces systèmes utilisent un rebouclage (« feedback » en anglais) de la sortie vers l'entrée du système, de façon à permettre une comparaison du signal mesuré en sortie du système (aussi appelé signal d'entrée du comparateur) avec une valeur de consigne (aussi appelée consigne dans la suite de la description).

Il est donc classique qu'un système d'asservissement comprenne un microcontrôleur équipé d'un comparateur qui permet, après une détection d'une égalité (ou d'une inégalité) du signal d'entrée et de la consigne, de générer un signal de comparaison (aussi appelé signal de sortie dans la suite de la description) afin, par exemple, de modifier directement le déroulement d'un algorithme d'asservissement, de changer l'état de certaine des sorties du système ou encore de commander la capture d'une valeur d'un compteur qui sera utilisée par l'algorithme pour ajuster les commandes du système.

On connaît de très nombreuses techniques de comparaison permettant de générer un signal de sortie, représentatif d'un écart entre un signal d'entrée et une consigne. Ce signal de comparaison varie entre des niveaux logiques haut et bas en fonction du résultat de la comparaison.

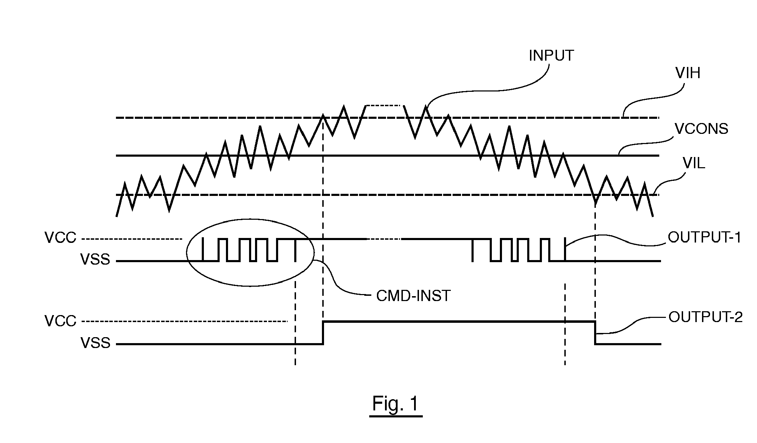

Comme illustré par la figure 1, la comparaison à « un seuil » est une première technique selon laquelle le signal de sortie OUTPUT_1 bascule vers le niveau logique haut VCC lorsque le signal d'entrée INPUT est supérieur ou égal à la consigne VCONS et vers le niveau logique bas VSS lorsque le signal d'entrée INPUT est inférieur à la consigne VCONS.

Cette technique de comparaison, relativement ancienne, a connu peu de succès, pour différentes raisons, et notamment la sensibilité aux bruits.

En effet, la présence d'un signal bruité à l'entrée du comparateur peut provoquer un fonctionnement aléatoire ou une panne du système, du fait que lorsque le signal bruité devient proche de la consigne, le comparateur, dit comparateur à un seuil, génère des commandes instables CMD_INST.

Pour remédier à ce problème, il est traditionnellement envisagé d'implémenter une hystérésis analogique sur le comparateur afin que le bruit porté par le signal d'entrée ne soit pas retransmis au système.

De façon plus précise et comme illustré par la figure 1, un comparateur à hystérésis (ou comparateur « à deux seuils ») (aussi appelé trigger de Schmitt) est caractérisé par deux seuils de commutation : un seuil de commutation bas VIL et un seuil de commutation haut VIH. Selon cette seconde technique, lorsque le signal d'entrée INPUT atteint le seuil de commutation haut VIH, le signal de sortie OUTPUT_2 commute du niveau logique bas VSS vers le niveau logique haut VCC et lorsque le signal d'entrée INPUT atteint le seuil de commutation bas VIL, le signal de sortie OUTPUT_2 commute du niveau logique haut VCC vers le niveau logique bas VSS.

Il est à noter que plus la différence entre le seuil de commutation haut VIH et le seuil de commutation bas VIL est importante, plus le comparateur sera fiable et insensible aux fluctuations parasites superposées au signal d'entrée INPUT. Cet écart de tension entre les deux seuils de commutation VIH et VIL est appelé hystérésis. La différence entre le seuil de commutation haut VIH et le seuil de commutation bas VIL constitue également la marge de l'immunité au bruit qui est l'écart de tension qu'un signal d'entrée peut avoir sans entraîner d'incident particulier sur le fonctionnement d'un système.

Bien que le comparateur à hystérésis ait représenté un progrès important dans le mécanisme de génération d'un signal de comparaison sans instabilité, la seconde technique connue présente néanmoins les désavantages d'être coûteuse en surface silicium et peu efficace. En effet, l'hystérésis est typiquement réglée à la valeur de bruit maximum qu'est supposé porter le signal à observer en sortie du système d'asservissement (c'est-à-dire le signal d'entrée du comparateur). Cette valeur de bruit maximum est d'autant plus difficile à estimer, que les microcontrôleurs sont développés pour une multitude d'applications et non une application spécifique. On pourrait envisager d'implémenter des hystérésis analogiques réglables sur les comparateurs. Cependant, cela rendrait cette seconde technique de l'art antérieur encore plus coûteuse en surface silicium.

Un autre inconvénient majeur de cette seconde technique connue réside dans le fait que les hystérésis introduisent un retard sur la disponibilité de l'information, retard qui s'ajoute au temps nécessaire à l'algorithme d'asservissement pour ajuster ses actions sur le système. Ainsi, cette latence entre égalité du signal d'entrée et de la consigne et réaction du système peut être préjudiciable à la précision du contrôle du système.

### 3. Objectifs de l'invention

L'invention a notamment pour objectif de pallier ces inconvénients de l'art antérieur. Plus précisément, un objectif de l'invention est de fournir une technique de comparaison de signaux analogiques qui soit simple à mettre en oeuvre et efficace, notamment en terme de prise de décision.

Un autre objectif de l'invention est de proposer une telle technique qui permette de supprimer, en sortie du comparateur, les oscillations intempestives générées lorsqu'un signal d'entrée bruité devient proche de la consigne donnée au comparateur.

L'invention a encore pour objectif de fournir une telle technique qui ne conduise pas à une augmentation notable de la taille du circuit intégré.

L'invention a également pour objectif de fournir une telle technique qui, dans au moins un mode de réalisation, soit peu coûteuse et adaptée à toutes les applications standards des microcontrôleurs et/ou des systèmes sur puces électroniques actuels.

Un dernier objectif de l'invention est de fournir une telle technique qui, dans un mode de réalisation particulier, soit notamment bien adaptée aux systèmes d'asservissement numérique.

### 4. Exposé de l'invention

Ces objectifs, ainsi que d'autres qui apparaîtront par la suite, sont atteints à l'aide d'un dispositif de comparaison, recevant un signal d'entrée analogique et une valeur de consigne, et délivrant un signal de sortie numérique, ledit signal de sortie étant susceptible de commuter entre un niveau logique haut et un niveau logique bas, ou réciproquement. Le dispositif comprend un comparateur à un seuil recevant ledit signal d'entrée et ladite valeur de consigne, ledit comparateur génère un signal résultant qui est fonction du résultat de la comparaison.

Selon l'invention, le dispositif comprend des moyens d'échantillonnage dudit signal résultant et des moyens de commande desdits moyens d'échantillonnage, permettant de bloquer lesdits moyens d'échantillonnage tant qu'un mécanisme de temporisation n'indique pas qu'une durée de temporisation déterminée est écoulée depuis la vérification d'au moins un critère d'instabilité prédéterminé, ledit mécanisme de temporisation étant réinitialisé avec ladite durée de temporisation à chaque fois que ledit au moins un critère d'instabilité prédéterminé est vérifié. Lesdits moyens d'échantillonnage permettent, s'ils ne sont pas bloqués, de copier ledit signal résultant en sortie dudit dispositif.

Ainsi, l'invention repose sur une approche tout à fait nouvelle et inventive de la génération d'un signal de comparaison dans un circuit intégré. En effet, l'invention propose d'associer un comparateur à un seuil et un mécanisme d'anti-rebond. Ce mécanisme d'anti-rebond permet de détecter les instabilités du signal résultant (c'est-à-dire les commandes instables générées en sortie du comparateur), et le cas échéant de les supprimer.

Pour ce faire, on utilise des moyens de commandes qui permettent, pendant la période de fonctionnement d'un mécanisme de temporisation, de désactiver l'échantillonnage de la sortie du comparateur, de façon à maintenir la tension résultante à son niveau logique courant. En outre, le mécanisme d'anti-rebond permet de donner l'information de l'égalité du signal d'entrée et de la consigne, et ce, contrairement à la technique de l'art antérieur précitée, sans aucun retard.

Selon un aspect avantageux de l'invention, ledit au moins un critère d'instabilité prédéterminé est une commutation dudit signal résultant.

Dans une première variante, le mécanisme de temporisation est réinitialisé sur les fronts montant ou descendant du signal résultant.

Il convient de préciser que par front montant, on entend une commutation d'un signal d'un niveau logique bas vers un niveau logique haut, le front descendant étant la commutation inverse.

Dans une deuxième variante, le mécanisme de temporisation est réinitialisé après un nombre déterminé de commutations successives du signal résultant.

De façon préférentielle, ladite durée de temporisation est supérieure à la période du bruit de plus basse fréquence que l'on veut supprimer.

L'invention repose sur l'observation suivante : on connaît généralement mieux la fréquence fondamentale d'un bruit présent sur une application que son niveau. Le cas le plus connu est celui du 50Hz du secteur, dont on sait que sa fréquence fondamentale peut bruiter des signaux basse fréquences, mais dont il est difficile lors de la conception d'un système d'évaluer le niveau de la fréquence 50Hz qui sera superposé au signal d'entrée.

Ainsi, l'invention propose un filtrage numérique des signaux haute fréquence (portés par le signal d'entrée) dont la période est inférieure à une durée de temporisation.

De façon avantageuse, lesdits moyens de commande comprennent des moyens de détection de commutation dudit signal résultant, générant un signal en échelon, appelé signal de détection, prenant successivement une première et une seconde valeur à chaque fois qu'une commutation est détectée. Ledit mécanisme de temporisation comprend une base de temps recevant sur une première entrée, appelée entrée de chargement, et sur une deuxième entrée, appelée entrée d'autorisation, ledit signal de détection et ledit signal de détection inversé, respectivement, de sorte que :
- quand ledit signal de détection prend ladite première valeur, ladite base de temps est pré-chargée par ladite durée de temporisation ; puis
- quand ledit signal de détection prend ladite seconde valeur, ladite base de temps autorise l'écoulement de ladite durée de temporisation pré-chargée.

La présente invention couvre un premier cas dans lequel la base de temps est un compteur numérique permettant d'incrémenter une valeur de départ jusqu'à une valeur d'arrivé. Le temps écoulé entre la valeur de départ et la valeur d'arrivé est égale à la durée de temporisation pré-chargée dans le compteur.

L'invention couvre également un second cas dans lequel la base de temps est un décompteur numérique permettant de décrémenter une valeur de départ jusqu'à une valeur d'arrivée. Le temps écoulé entre la valeur de départ et la valeur d'arrivé est égale à la durée de temporisation pré-chargée dans le décompteur.

Préférentiellement, lesdits moyens de détection de commutation comprennent :
- une bascule recevant ledit signal résultant et délivrant un signal résultant retardé ;
- une porte logique OU-EXCLUSIF recevant ledit signal résultant et ledit signal résultant retardé et délivrant ledit signal de détection, de sorte que :
   o si ledit signal résultant et ledit signal résultant retardé sont à des niveaux logique différents, ladite porte logique OU-EXCLUSIF fixe ledit signal de détection à ladite première valeur ;
   o si ledit signal résultant et ledit signal résultant retardé sont au même niveau logique, ladite porte logique OU-EXCLUSIF fixe ledit signal de détection à ladite seconde valeur.

Avantageusement, ladite base de temps comprend un rebouclage de la sortie de ladite base de temps vers ladite entrée d'autorisation, de façon à bloquer ladite base de temps lorsque ladite durée de temporisation est écoulée, jusqu'à la détection d'une commutation dudit signal résultant.

Préférentiellement, ladite base de temps est programmable.

Ainsi, il est possible de configurer les paramètres de la base de temps (durée de temporisation, valeur de départ, valeur d'arrivée, ...) en fonction de la ou les fréquences du bruit à supprimer.

Il est en outre possible d'adapter de façon dynamique les paramètres de la base de temps en fonction de la fréquence de bruit détectée sur le signal d'entrée.

Dans un mode de réalisation préférentiel de l'invention, le dispositif comprend des moyens de resynchronisation entre ledit comparateur et lesdits moyens de commande, de façon à resynchroniser ledit signal résultant sur un signal d'horloge.

D'une façon générale, le signal en sortie d'un comparateur (signal résultant) est un signal asynchrone qui nécessite d'être resynchronisé sur une horloge, de façon à pouvoir être utilisé par des circuits logiques synchrones.

Selon l'invention, les moyens de resynchronisation assurent également la protection des moyens de commande contre les aléas logiques générés en sortie du comparateur.

Par aléa logique, on entend une succession d'un front montant et d'un front descendant se produisant pendant un espace de temps inférieur à la période du signal d'horloge.

Selon un aspect avantageux de l'invention, lesdits moyens de resynchronisation comprennent une bascule permettant de copier ledit signal résultant en sortie, à chaque front actif dudit signal d'horloge.

L'invention concerne également un circuit électronique comprenant un dispositif de comparaison tel que décrit ci-dessus.

### 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1, déjà commentée en relation avec l'art antérieur, est un ensemble de graphiques montrant, d'une part l'évolution du signal de comparaison généré en sortie d'un comparateur à un seuil classique, et d'autre part l'évolution du signal de comparaison généré en sortie d'un comparateur à hystérésis classique, en fonction de l'évolution d'un signal d'entrée bruité ;
- la figure 2 présente le schéma d'un dispositif de comparaison selon un mode de réalisation préférentiel de l'invention ; et
- la figure 3 illustre le fonctionnement du dispositif de comparaison de la figure 2.

### 6. Description d'un mode de réalisation de l'invention

Le principe général de l'invention repose sur l'adjonction d'un mécanisme d'anti-rebond en sortie d'un comparateur.

Selon l'invention, des moyens de commande comprennent des moyens de détection, permettant de détecter un changement d'état en sortie du comparateur, et le cas échéant de réinitialiser un mécanisme de temporisation avec une durée de temporisation déterminée. Ces moyens de commande permettent d'empêcher l'échantillonnage de la sortie du comparateur après une détection positive d'une commande instable.

Par souci de simplification de la description, on se limitera, dans toute la suite de ce document, à décrire un dispositif de comparaison fonctionnant avec un mécanisme de temporisation équipé d'un décompteur numérique. L'Homme du Métier étendra sans difficulté cet enseignement à un dispositif de comparaison fonctionnant avec un mécanisme de temporisation équipé d'un compteur numérique.

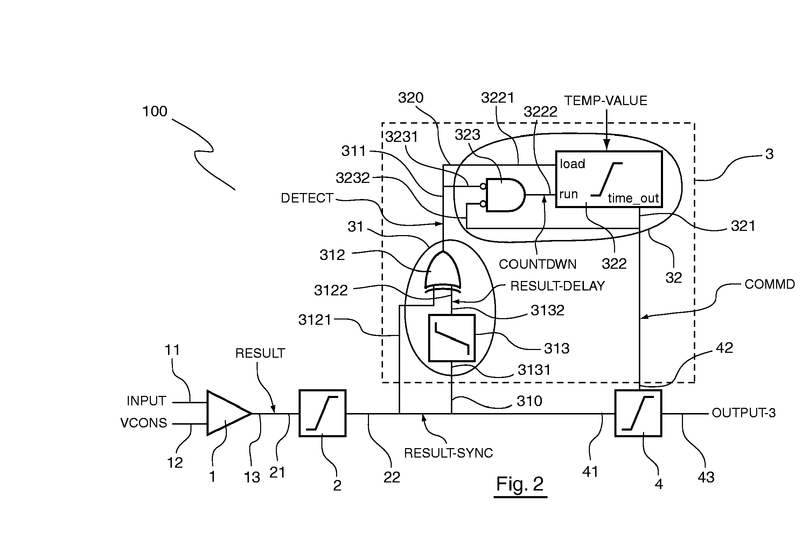

On décrit désormais en relation avec la **figure 2** un dispositif de comparaison 100 selon un mode de réalisation préférentiel de l'invention.

Dans ce mode de réalisation, le dispositif de comparaison 100 selon l'invention comprend :
- des moyens de commande 3 incluant un mécanisme de temporisation 32 spécifiques à l'invention ;
- des moyens d'échantillonnage 4 spécifiques à l'invention ; et
- un comparateur à un seuil 1 de type classique en soi (dont le fonctionnement a déjà été décrit ci-dessus en relation avec la figure 1).

Le comparateur 1 reçoit sur une première entrée 11 un signal d'entrée analogique INPUT et sur une deuxième entrée 12 une valeur de consigne VCONS, et délivre en sortie 13 un signal résultant RESULT qui, en fonction du résultat de la comparaison, est égal soit à la valeur de l'alimentation de haute tension VCC (généralement de 5V) (aussi appelée par la suite niveau logique haut) soit à la valeur de l'alimentation de basse tension VSS (généralement de 0V) (aussi appelée par la suite niveau logique bas).

Il est à noter que le signal résultant RESULT est un signal asynchrone. Afin d'éviter un disfonctionnement de la partie logique (c'est-à-dire les circuits synchronisés sur une horloge) du dispositif, on synchronise le signal résultant RESULT sur un signal d'horloge CLOCK. Pour ce faire, on utilise des moyens de resynchronisation 2, montés en série avec le comparateur 1. Les moyens de resynchronisation 2 reçoivent en entrée 21 le signal résultant RESULT et fournissent en sortie 22 un signal synchronisé RESULT_SYNC.

Ces moyens de resynchronisation 2 comprennent une bascule de type D (non représentée), active sur front montant, qui permet de copier le signal résultant RESULT en sortie 22 à chaque front montant du signal d'horloge CLOCK, et de maintenir le signal synchronisé RESULT_SYNC à son niveau logique courant jusqu'au prochain front montant du signal d'horloge CLOCK.

Dans le mode de réalisation illustré, les moyens de commande 3 comprennent des moyens de détection 31 agissant sur le mécanisme de temporisation 32.

Comme on le verra dans la suite de la description, ces moyens de détection 31 permettent de réinitialiser le mécanisme de temporisation 32 à chaque commutation du signal synchronisé RESULT_SYNC d'une part et d'empêcher l'activation des moyens d'échantillonnage 4 d'autre part, de façon à supprimer les commandes instables CMD_INST du signal synchronisé RESULT_SYNC.

De façon plus détaillée, les moyens de détection 31 reçoivent sur une entrée 310 le signal synchronisé RESULT_SYNC et fournissent en sortie 311 un signal de détection DETECT qui commute vers le niveau logique haut VCC puis vers le niveau logique bas VSS à chaque fois qu'une commutation du signal synchronisé RESULT_SYNC est détectée. Ainsi, les moyens de détection 31 permettent de générer un échelon à chaque front montant et descendant du signal synchronisé RESULT_SYNC.

Plus précisément encore, les moyens de détection 31 comprennent une porte logique OU-EXCLUSIF 312 et une bascule 313, montée en série sur l'une des entrées de la porte logique OU-EXCLUSIF 312.

La bascule 313 reçoit sur une entrée 3131 le signal synchronisé RESULT_SYNC et délivre en sortie 3132 un signal retardé RESULT_ DELAY. Cette bascule 313 permet ainsi d'introduire un retard égal à une période du signal d'horloge CLOCK sur le signal synchronisé RESULT_SYNC.

La porte logique OU-EXCLUSIF 312 reçoit sur une première entrée 3121 le signal synchronisé RESULT_SYNC et sur une deuxième entrée 3122 le signal retardé RESULT_ DELAY (délivré en sortie de la bascule 313).

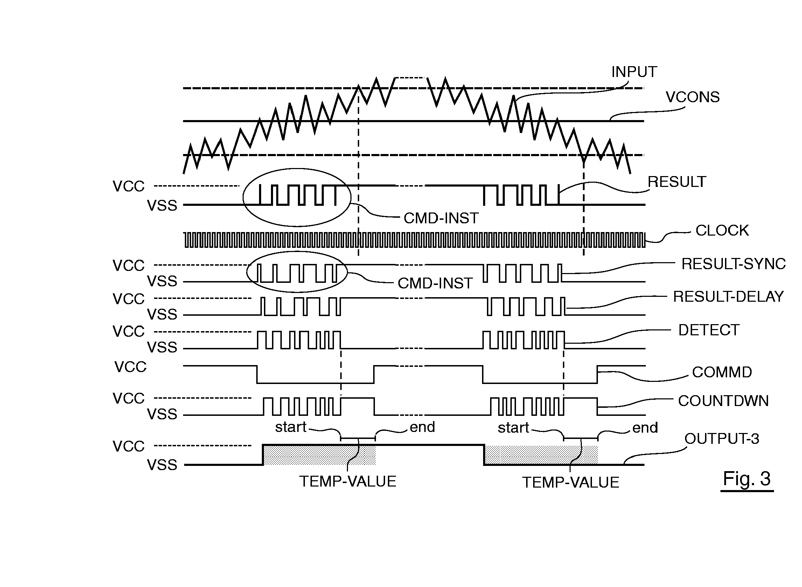

Comme illustré par la **figure 3**, lorsque le signal synchronisé RESULT_SYNC et le signal retardé RESULT_ DELAY sont à des niveaux logique différents, alors le signal de détection DETECT, délivré en sortie 311, prend la valeur du niveau logique haut VCC.

A l'inverse, lorsque le signal synchronisé RESULT_SYNC et le signal retardé RESULT_ DELAY sont au même niveau logique, alors le signal de détection DETECT, délivré en sortie 311, prend la valeur du niveau logique bas VSS.

Le signal de détection DETECT est directement appliqué sur l'entrée 320 du mécanisme de temporisation 32 ; ce dernier délivre alors en sortie 321 un signal de commande COMMD qui, en fonction de l'état courant du mécanisme de temporisation, est égal soit au niveau logique haut VCC soit au niveau logique bas VSS.

Dans le présent mode de réalisation, le mécanisme de temporisation 32 comprend un décompteur numérique 322 et une porte logique ET à entrées inversées 323, montée en série sur l'une des entrées du décompteur numérique 322.

La porte logique ET à entrées inversées 323 reçoit sur une première entrée 3231 le signal de détection DETECT et sur une deuxième entrée 3232 le signal de commande COMMD (délivré en sortie 321 du mécanisme de temporisation), et délivre en sortie 3233 un signal d'activation COUNTDWN.

On décrit ci-après en référence à la figure 3, le fonctionnement du dispositif de comparaison 100 selon un mode de réalisation préférentiel de l'invention.

Ainsi, lorsque le signal de détection DETECT et le signal de commande COMMD sont chacun au niveau logique bas VSS, c'est-à-dire lorsque les moyens de détection ne détectent aucune commutation du signal synchronisé RESULT_SYNC et lorsque le mécanisme de temporisation est en cours de décomptage, alors le signal d'activation COUNTDWN prend la valeur du niveau logique haut VCC.

En revanche, lorsque le signal de détection DETECT est au niveau logique haut VCC (c'est-à-dire en cas de détection d'une commutation du signal synchronisé RESULT_SYNC) et/ou lorsque le signal de commande COMMD est au niveau logique haut VCC (c'est-à-dire lorsque le mécanisme de temporisation a fini de décompter), alors le signal d'activation COUNTDWN prend la valeur du niveau logique bas VSS.

Comme illustré par la figure 2, le décompteur numérique 322 reçoit sur une première entrée LOAD, dite entrée de chargement, le signal de détection DETECT et sur une deuxième entrée RUN, dite entrée d'autorisation, le signal d'activation COUNTDWN.

Le décompteur numérique 322 est un séquenceur logique qui permet de décrémenter une valeur de départ START (par exemple « 10 ») d'une unité, à chaque coup d'horloge, jusqu'à une valeur d'arrivée END (généralement « 0 »). Le temps écoulé entre la valeur de départ et la valeur d'arrivé est appelé durée de temporisation TEMP_VALUE. Comme déjà indiqué, cette durée de temporisation TEMP_VALUE est choisie afin d'être supérieure à la période du bruit de plus basse fréquence porté par le signal d'entrée INPUT.

À titre d'exemple, dans le cas d'un signal d'horloge CLOCK de 8MHz, pour un signal d'entrée de 15KHz sur lequel est superposé un bruit de 1MHz, la valeur de départ START peut être réglée à « 16 », ce qui donne une durée de temporisation TEMP_VALUE de 2µs.

Ainsi, lorsque le signal de détection DETECT est au niveau logique haut VCC, le décompteur numérique 322 est réinitialisé, c'est-à-dire qu'on recharge le décompteur numérique avec la valeur de départ START.

Par ailleurs, lorsque le signal d'activation COUNTDWN est au niveau logique haut VCC, le décompteur numérique 322 autorise la décrémentation de la valeur de départ START.

On note que dans le présent mode de réalisation, la porte logique ET à entrées inversées 323 permet d'empêcher l'activation simultanée des entrées LOAD et RUN. En d'autres termes, on interdit le cas où le signal de détection DETECT et le signal d'activation COUNTDWN sont tous les deux au niveau logique haut VCC.

Il est à noter également que lorsque la durée de temporisation TEMP_VALUE est écoulée, la porte logique ET à entrées inversées 323 fixe le signal d'activation COUNTDWN au niveau logique bas VSS, de façon à bloquer le décompteur numérique 322 sur la valeur d'arrivée END, jusqu'à la détection d'une commutation du signal synchronisé RESULT_SYNC.

Comme illustré par la figure 2, les moyens d'échantillonnage 4 reçoivent sur une première entrée 41 le signal synchronisé RESULT_SYNC et sur une deuxième entrée 42 le signal de commande COMMD délivré en sortie TIME_OUT du décompteur numérique 322.

Ces moyens d'échantillonnage 4 comprennent une bascule de type D (non représentée), active sur front montant, de sorte que si la valeur du signal de commande COMMD est égale à la valeur du niveau logique haut VCC, alors le signal synchronisé RESULT_SYNC est recopié en sortie 43.

En revanche (figure 3), si la valeur du signal de commande COMMD est égale à la valeur du niveau logique bas VSS, alors le signal de sortie OUTPUT_3 est maintenu à son niveau logique courant.

En résumé, le dispositif de comparaison, tel que proposé par l'invention, présente de nombreux avantages, dont une liste non exhaustive est donnée ci-dessous :
- amélioration de la prise de décision ; en effet, l'invention permet de détecter les commutations du signal de sortie du comparateur et fournir sans retard l'information d'égalité du signal d'entrée et de la consigne ;
- amélioration de la stabilité ; en effet, l'invention permet de supprimer les commandes instables générées en sortie du comparateur lorsque le signal d'entrée devient proche de la consigne, et ce quel que soit le niveau de bruit en entrée.

Bien entendu, l'invention n'est pas limitée à l'exemple de réalisation mentionné ci-dessus.

En particulier, l'Homme du Métier pourra, en fonction de la nature de l'application, modifier la logique de comparaison. Notamment, il est possible d'envisager la programmation du mécanisme de temporisation, de sorte que le mécanisme de temporisation adapte de façon dynamique ses paramètres de temporisation TEMP_VALUE, START et END à la fréquence du bruit détectée.

De même, le mécanisme de temporisation peut être implémenté de toute autre manière, à savoir notamment avec un compteur numérique et avec une porte logique NON-OU.

D'une façon générale, dans d'autres exemples de réalisation, les valeurs de TEMP_VALUE, START, END, VCC, et VSS peuvent être différentes de celles données dans le cas du mode de réalisation préférentiel exposé ci-dessus.

Bien que l'invention ait été décrite ci-dessus en relation avec un nombre limité de modes de réalisation, l'homme du métier, à la lecture de la présente description, comprendra que d'autres modes de réalisation peuvent être imaginés sans sortir du cadre de la présente invention.

## Revendications

1. Dispositif de comparaison (100), recevant un signal d'entrée analogique (INPUT) et une valeur de consigne (VCONS), et délivrant un signal de sortie numérique (OUTPUT_3), ledit signal de sortie étant susceptible de commuter entre un niveau logique haut (VCC) et un niveau logique bas (VSS), ou réciproquement,
ledit dispositif (100) comprenant un comparateur à un seuil (1) recevant ledit signal d'entrée et ladite valeur de consigne, ledit comparateur générant un signal résultant (RESULT) qui est fonction du résultat de la comparaison,
**caractérisé en ce qu'**il comprend des moyens d'échantillonnage (4) dudit signal résultant et des moyens de commande (3) desdits moyens d'échantillonnage, permettant de bloquer lesdits moyens d'échantillonnage (4) tant qu'un mécanisme de temporisation (32) n'indique pas qu'une durée de temporisation déterminée (TEMP_VALUE) est écoulée depuis la vérification d'au moins un critère d'instabilité prédéterminé, ledit mécanisme de temporisation (32) étant réinitialisé avec ladite durée de temporisation à chaque fois que ledit au moins un critère d'instabilité prédéterminé est vérifié,
et **en ce que** lesdits moyens d'échantillonnage (4) permettent, s'ils ne sont pas bloqués, de copier ledit signal résultant (RESULT) en sortie dudit dispositif (100).

2. Dispositif de comparaison selon la revendication 1, **caractérisé en ce que** ledit au moins un critère d'instabilité prédéterminé est une commutation dudit signal résultant.

3. Dispositif de comparaison selon la revendication 1, **caractérisé en ce que** ladite durée de temporisation est supérieure à la période du bruit de plus basse fréquence que l'on veut supprimer.

4. Dispositif de comparaison selon l'une quelconque des revendications 2 et 3, **caractérisé en ce que** lesdits moyens de commande comprennent des moyens de détection (31) de commutation dudit signal résultant (RESULT), générant un signal en échelon, appelé signal de détection (DETECT), prenant successivement une première et une seconde valeur à chaque fois qu'une commutation est détectée,
et **en ce que** ledit mécanisme de temporisation (32) comprend une base de temps (322) recevant sur une première entrée, appelée entrée de chargement (LOAD), et sur une deuxième entrée, appelée entrée d'autorisation (RUN), ledit signal de détection et ledit signal de détection inversé, respectivement, de sorte que :
- quand ledit signal de détection prend ladite première valeur, ladite base de temps est pré-chargée par ladite durée de temporisation ; puis
- quand ledit signal de détection prend ladite seconde valeur, ladite base de temps autorise l'écoulement de ladite durée de temporisation pré-chargée.

5. Dispositif de comparaison selon la revendication 4, **caractérisé en ce que** lesdits moyens de détection (31) de commutation comprennent :
- une bascule (313) recevant ledit signal résultant et délivrant un signal résultant retardé (RESULT_DELAY) ;
- une porte logique OU-EXCLUSIF (312) recevant ledit signal résultant et ledit signal résultant retardé et délivrant ledit signal de détection, de sorte que :
- si ledit signal résultant et ledit signal résultant retardé sont à des niveaux logique différents, ladite porte logique OU-EXCLUSIF fixe ledit signal de détection à ladite première valeur ;
- si ledit signal résultant et ledit signal résultant retardé sont au même niveau logique, ladite porte logique OU-EXCLUSIF fixe ledit signal de détection à ladite seconde valeur.

6. Dispositif de comparaison selon la revendication 4, **caractérisé en ce que** ladite base de temps (322) comprend un rebouclage de la sortie de ladite base de temps vers ladite entrée d'autorisation (RUN), de façon à bloquer ladite base de temps lorsque ladite durée de temporisation est écoulée, jusqu'à la détection d'une commutation dudit signal résultant.

7. Dispositif de comparaison selon la revendication 6, **caractérisé en ce que** ladite base de temps (322) est programmable.

8. Dispositif de comparaison selon l'une quelconque des revendications 1 à 7, **caractérisé en ce qu'**il comprend des moyens de resynchronisation (2) entre ledit comparateur (1) et lesdits moyens de commande (3), de façon à resynchroniser ledit signal résultant sur un signal d'horloge.

9. Dispositif de comparaison selon la revendication 8, **caractérisé en ce que** lesdits moyens de resynchronisation comprennent une bascule permettant de copier ledit signal résultant en sortie, à chaque front actif dudit signal d'horloge.

10. Circuit électronique **caractérisé en ce qu'**il comprend un dispositif de comparaison (100) selon l'une quelconque des revendications 1 à 9.
